# FASCICULE DE BREVET EUROPEEN

(11) **EP 2 075 826 B1**
(45) Date de publication et mention de la délivrance du brevet: **07.08.2013**
(21) Numéro de dépôt: 08172510.3
(22) Date de dépôt: 22.12.2008
(51) Int. Cl.: H01L 21/321, H01L 21/762

(54) **Procédé de fabrication d'un substrat semiconducteur-sur-isolant comprenant une étape d'enrichissement en Ge localisé**
Verfahren zur Herstellung eines Halbleiter-auf-Isolator-Substrats, das eine Anreicherungsetappe mit lokalisiertem Germanium umfasst
Method of manufacturing a semiconductor-on-insulant substrate comprising a step with localised Ge enrichment

(30) Priorité: 27.12.2007 FR 0760380
(43) Date de publication de la demande: 01.07.2009
(73) Titulaire: Commissariat à l'Énergie Atomique et aux Énergies Alternatives, 75015 Paris (FR)
(72) Inventeur: Vincent, Benjamin, 1050, IXELLES (BE); Clavelier, Laurent, 38000, GRENOBLE (FR); Damlencourt, Jean-François, 38190, LAVAL (FR)
(74) Mandataire: Ilgart, Jean-Christophe

(56) Documents cités:
- EP-A- 1 868 232
- US-A1- 2003 006 461
- US-A1- 2003 013 305
- US-A1- 2005 245 092
- US-B1- 6 180 499
- US-B2- 7 067 400

## Description

### DOMAINE TECHNIQUE

L'invention se rapporte à un procédé de fabrication d'un substrat semiconducteur sur isolant comprenant une étape d'enrichissement en Ge localisé.

Les technologies de la microélectronique ont jusqu'à présent été principalement basées sur l'utilisation du silicium. Ce matériau arrive cependant aux limites de son utilisation pour une diminution continuelle des dispositifs MOSFET.

Dans le cadre de la fabrication de dispositifs de plus en plus rapides, on envisage fortement de substituer le silicium par un matériau semiconducteur aux mobilités de porteurs plus importantes. Le germanium répond théoriquement à ce critère pour une augmentation de la mobilité à la fois des trous et des électrons.

D'un point de vue expérimental, le germanium semble être particulièrement adapté pour des pMOSFET (conduction par les trous) de haute performance. Son intérêt comme substrat pour des nMOSFET (conduction par les électrons) n'a par contre pas encore été prouvé expérimentalement et est aujourd'hui très discuté. Dans le cadre de la fabrication de technologies CMOS ("Complementary Metal Oxide Semiconductor") de hautes performances, une co-intégration de substrats silicium et germanium est donc fortement envisagée dans la recherche des substrats innovants pour la microélectronique. Ceci permet la co-intégration de nMOSFET sur silicium avec des pMOSFET sur germanium.

Pour augmenter encore plus les performances électriques des transistors, une co-intégration Silicium-Germanium sur isolant est aussi envisagée. Le nMOSFET se trouve ainsi sur un substrat SOI ("Silicon On Insulator" pour silicium-sur-isolant) et le pMOSFET sur un substrat GeOI ("Germanium On Insulator" pour germanium-sur-isolant). La couche d'isolant sur laquelle reposent les matériaux silicium et germanium permet la diminution des courants de fuites de substrats respectifs et ainsi une optimisation des performances électriques des deux types de transistors : n et p.

### ETAT DE L'ART

Différentes techniques de fabrication de substrats Germanium sur Isolant ou Silicium-Germanium sur Isolant (SGOI) sont proposées dans la littérature : le procédé SMART CUT^{™}, la technique RMG pour "Rapid Melt Growth", et le procédé nommé "enrichissement en germanium". Dans la littérature consacrée, ce procédé est parfois dénommé « condensation du germanium ».

Cette dernière technique permet soit la réalisation de substrat Germanium-sur-Isolant pleine plaque, soit la fabrication de structures localisées de Germanium-sur-Isolant. Elle permet d'autant plus la réalisation de structures Silicium-Germanium sur Isolant (SGOI). Le procédé est basé sur l'oxydation sélective du silicium par rapport au germanium sous atmosphère sèche à haute température, et sur la miscibilité totale du germanium et du silicium dans un alliage silicium-germanium quelle que soit la concentration en germanium dans cet alliage (voir T. TEZUKA et al., Jpn. J. Appl. Phys., Vol. 40 (2001), pages 2 866 à 2 874).

La première étape du procédé consiste en l'épitaxie d'une couche de SiGe sur un substrat Silicium-sur-Isolant. La concentration et l'épaisseur de la couche de SiGe épitaxiée sont préférentiellement choisies pour que la couche de SiGe soit dans un état de contrainte pseudomorphe. La deuxième étape est une oxydation sèche à haute température (supérieure à 900°C) permettant la formation exclusive de l'oxyde SiO₂ dû à une enthalpie de formation (négative) plus importante que celle du GeO₂. Au cours de l'oxydation, le germanium se trouve piégé entre deux barrières : l'interface avec l'oxyde enterré (BOX), fixe, et l'interface d'oxydation en mouvement. Dû à la haute température d'oxydation, le germanium diffuse dans la couche de SiGe délimitée par ces deux barrières, homogénéisant ainsi l'alliage SiGe. L'épaisseur du SiGe diminuant, la concentration en germanium s'enrichit durant l'oxydation, formant ainsi un substrat SGOI. La concentration de Ge peut atteindre 100 % par cette technique pour la formation d'un substrat GeOI pur avec un temps d'oxydation adapté.

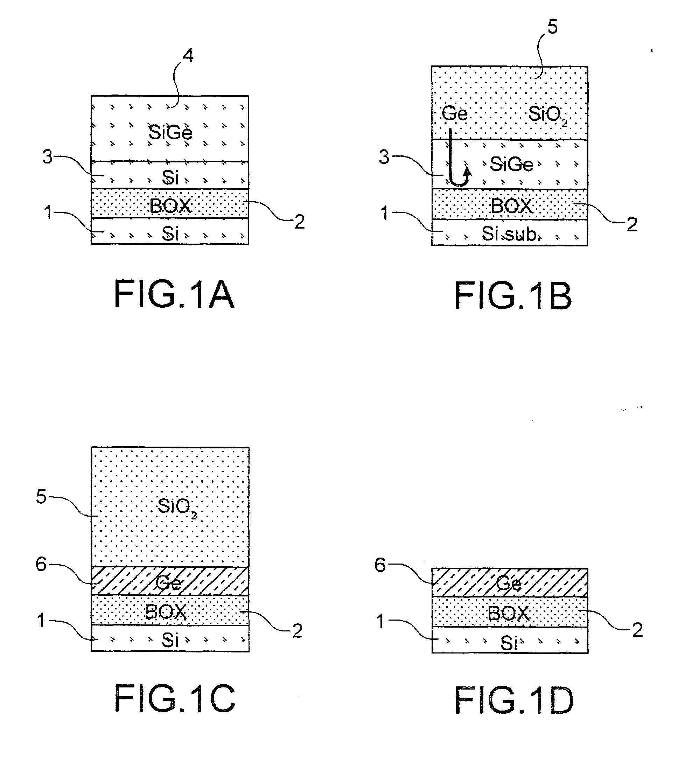

Les figures 1A à 1D illustrent ce procédé. La figure 1A montre un substrat de silicium 1 supportant une couche d'oxyde enterrée 2 BOX (pour "buried oxide") et une couche mince de silicium 3 de qualité électronique. Une couche 4 de SiGe a été épitaxiée sur la couche mince 3. Une couche d'oxyde de silicium 5 est ensuite formée par oxydation sèche à haute température sur la couche de SiGe 4 (voir la figure 1B). Le germanium de l'alliage SiGe condense alors sur la couche d'oxyde enterrée 2. On obtient alors la structure représentée à la figure 1C et qui comprend une couche de germanium 6 reposant sur la couche d'oxyde enterrée 2 et supportant une couche d'oxyde de silicium 5. La couche d'oxyde 5 peut alors être éliminée pour révéler la couche de germanium 6. C'est ce qui est illustré sur la figure 1D.

Le procédé d'enrichissement est le seul procédé de fabrication de substrat GeOI ou SGOI par lequel une co-intégration planaire de structures SOI et GeOI, ou SGOI, peut être obtenue. Ceci peut être réalisable par deux approches.

Une première approche consiste à réaliser une oxydation localisée. Les zones locales d'enrichissement sont définies par les ouvertures d'un masque protecteur de l'oxydation déposé préalablement sur la structure SiGe sur SOI.

Une deuxième approche consiste en une oxydation de structures locales de type îlots de SiGe sur SOI, gravés après épitaxie de la couche de SiGe sur un substrat SOI. Cette approche est décrite dans le document "Dislocation-free formation of relaxed SiGe-on-insulator layers" de T. TEZUKA et al., Appl. Phys. Lett., Vol. 80, n° 19, 13 mai 2002, pages 3 560 à 3 562.

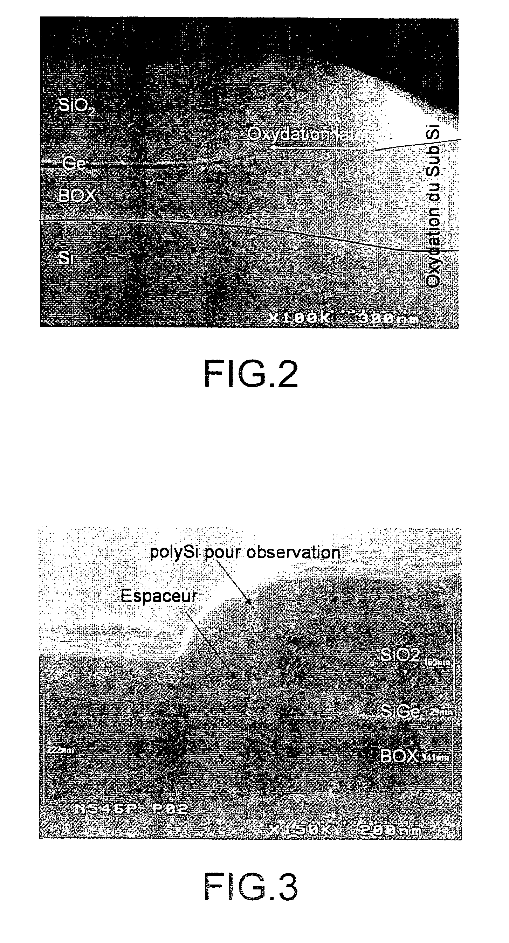

Pour cette deuxième approche, deux problématiques ont expérimentalement été mises en évidence. Elles sont illustrées par la figure 2. Une première problématique résulte de la diminution latérale des motifs due à une oxydation latérale de ceux-ci. Cette diminution des motifs entraîne de plus des enrichissements en germanium différents selon leurs tailles initiales : les petits motifs s'enrichissent en effet plus vite que les gros. Une deuxième problématique résulte de l'oxydation du substrat Si à travers l'oxyde enterré en dehors des zones actives. Cette problématique est d'autant plus critique pour les oxydes enterrés fins. Elle influe sur une déformation locale de l'oxyde enterré entraînant une déformation (soulèvement) de la couche de germanium condensé en bord de zone active.

Face à la première problématique (l'oxydation latérale), la fabrication d'espaceurs (avec un matériau imperméable à l'oxygène tel que le nitrure de silicium) de part et d'autre des zones actives SiGe/Si proposée par IBM (voir le brevet US 7 067 400), peut être une solution.

La figure 3 représente l'enrichissement de telles structures, îlots de SiGe/Si avec espaceurs. Les espaceurs empêchent l'oxydation latérale de la structure, mais n'empêchent pas la déformation des couches via l'oxydation à travers l'oxyde enterré en dehors des zones actives. On observe en effet sur la figure 3 un gonflement de l'oxyde enterré de 80 nm déformant l'extrémité de la couche de SiGe condensée à proximité des espaceurs.

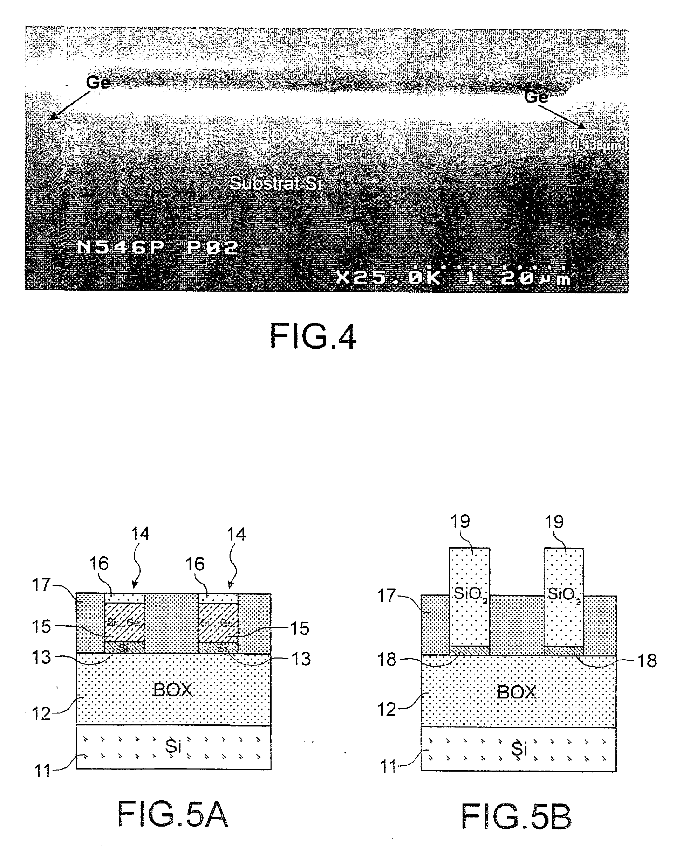

Dans l'art antérieur, la résolution de cette deuxième problématique n'est pas traitée. Cette problématique est cependant très critique dans le cadre de la réalisation d'un procédé d'enrichissement localisé puisqu'elle influe sur la planarité des structures. La figure 4 montre une caractérisation MEB (microscope électronique à balayage) réalisée sur deux îlots voisins après condensation. Le gonflement de l'oxyde enterré entre ces deux îlots montre clairement qu'il y a une perte de planarité sur la structure finale, critique pour les étapes suivantes de fabrication de transistors.

Le document US 2003/013 305 A1 divulgue un procédé d'obtention de couches de SiGe sur isolant. Sur un substrat SOI comportant une couche d'oxyde de silicium enterrée, on dépose successivement sur la couche superficielle de silicium : une couche de SiGe, une couche de silicium, une couche d'oxyde de silicium, une couche de silicium polycristallin et une couche d'oxyde de silicium. La couche de SiGe est donc comprise entre deux couches de silicium. Des tranchées sont alors formées dans l'empilement, jusqu'à la couche d'oxyde enterrée, pour isoler des îlots. Une couche d'oxyde de silicium est alors formée pour encapsuler chaque îlot. Cette couche d'oxyde de silicium a pour but de protéger la structure des îlots lors d'un traitement thermique haute température subséquent afin d'éviter que les îlots ne se mettent en boule. Lors du traitement thermique, le germanium de la couche de SiGe diffuse dans les couches de silicium voisines, ce qui provoque la constitution d'une couche unique en SiGe. Ce procédé ne permet pas l'obtention d'une couche de germanium pur sur isolant.

US 2003/006461 A1 divulgue un autre procédé d'obtention de couches de SiGe sur isolant avec un masque de protection en nitrure sur les flancs de la couche de SiGe.

### EXPOSE DE L'INVENTION

L'invention proposée permet de réaliser des zones localisées de GeOI et de SGOI par oxydation de zones locales de SiGe épitaxiées sur SOI sans diminution de taille de ces zones et sans déformation des couches de l'empilement (oxyde enterré ou couche de germanium), assurant donc un maintien de la planarité des couches.

L'invention consiste en un procédé d'enrichissement de structures localisée SiGe épitaxiées sur SOI entourées d'un masque d'oxydation. Ce masque protège à la fois les zones d'enrichissement d'une oxydation latérale et à la fois l'oxyde enterré en dehors des zones d'enrichissement de s'oxyder (préférentiellement ce masque est en nitrure de silicium).

La structure initiale avant enrichissement fait préférentiellement intervenir une couche d'oxyde sur la couche de SiGe initiale pour éviter toute formation de sous-oxyde de germanium dans la rampe de montée en température jusqu'à la température d'enrichissement.

L'invention a donc pour objet un procédé de fabrication d'un substrat semiconducteur-sur-isolant à partir d'un substrat SOI comportant une couche superficielle de silicium sur une couche électriquement isolante, dite couche isolante enterrée, une couche de Si₁₋ₓGeₓ étant formée sur la couche superficielle de silicium, le procédé comprenant les étapes suivantes :
- formation d'une couche d'oxyde de silicium sur la couche de Si₁₋ₓGeₓ,
- gravure de l'empilement constitué par la couche superficielle de silicium, la couche de Si₁₋ₓGeₓ et la couche d'oxyde de silicium, la gravure étant menée soit jusqu'à la couche isolante enterrée pour obtenir une structure gravée avec au moins un îlot dudit empilement, soit jusqu'à la couche superficielle de silicium pour obtenir une structure gravée avec au moins une zone de silicium et au moins un îlot dudit empilement,
- formation d'un masque de protection de l'oxydation sur la structure gravée, la formation du masque de protection de l'oxydation comprenant : le dépôt d'une couche de protection de l'oxydation sur la structure gravée, l'épaisseur de la couche de protection de l'oxydation étant supérieure à l'épaisseur cumulée de la couche superficielle de silicium et de la couche de Si₁₋ₓGeₓ et inférieure à l'épaisseur de l'empilement, et la planarisation de la couche de protection de l'oxydation jusqu'à révéler la couche d'oxyde de silicium de l'îlot,
- condensation du germanium de la couche de Si₁₋ₓGeₓ de l'îlot, par oxydation sèche à une température supérieure à 900°C de la couche de Si₁₋ₓGeₓ de l'îlot, pour obtenir un îlot comprenant une couche enrichie en germanium, voire une couche de germanium, sur la couche isolante enterrée, surmontée d'une couche d'oxyde de silicium.

Dans ce mode particulier de réalisation, le procédé peut comprendre en outre, après le dépôt de la couche de protection de l'oxydation, le dépôt d'une couche de recouvrement sur la couche de protection de l'oxydation, l'étape de planarisation comprenant le polissage mécano-chimique de la couche de recouvrement avec arrêt sur la partie de la couche de protection de l'oxydation située sur l'îlot, puis la gravure simultanée de la couche de protection de l'oxydation et de la couche de recouvrement avec arrêt sur la couche de protection de l'oxydation jusqu'à obtenir ledit masque.

Le procédé peut comprendre en outre, après l'étape de condensation du germanium, une étape d'élimination du masque de protection de l'oxydation et de la couche d'oxyde de silicium surmontant la couche enrichie en germanium.

Le procédé selon la présente invention permet d'obtenir au moins un îlot (ou mesa) comprenant une couche de silicium-germanium, voire une couche de germanium sur la couche électriquement isolante du substrat. Il permet aussi une co-intégration silicium et silicium-germanium (ou simplement germanium) sur isolant.

Selon un mode particulier de mise en oeuvre l'étape de condensation du germanium comprend une répétition d'étapes d'oxydation et de désoxydation. Cette répétition d'étapes d'oxydation et de désoxydation peut être menée pour que ladite couche d'oxyde de silicium surmontant ladite couche enrichie en germanium ne dépasse pas le masque de protection de l'oxydation. Eventuellement, le masque de protection de l'oxydation est formé dans un état de contrainte en tension ou en compression.

### BREVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1D, déjà décrites, illustrent le procédé appelé "enrichissement en germanium", selon l'art connu ;
- la figure 2 est une vue partielle en coupe d'un substrat SOI sur lequel on a réalisé, conformément à l'art antérieur, une oxydation de structures locales de type îlots de SiGe gravés après épitaxie d'une couche de SiGe ;
- la figure 3 est une vue partielle en coupe d'un substrat SOI sur lequel on a réalisé, conformément à l'art antérieur, une oxydation de structures locales de types îlots de SiGe, comme pour la figure 2, mais avec des espaceurs ;
- la figure 4 représente une caractérisation MEB (microscope électrique à balayage) réalisée sur deux îlots voisins après enrichissement en germanium, pour une structure de l'art antérieur ;
- les figures 5A et 5B illustrent le principe du procédé de fabrication selon l'invention, avec masque de protection de l'oxydation latérale et de l'oxydation à travers la couche isolante enterrée, selon une première variante de mise en oeuvre ;
- les figures 6A à 6G illustrent différentes étapes du procédé selon l'invention, selon un mode particulier de mise en oeuvre ;
- les figures 7A et 7B illustrent le principe du procédé de fabrication selon l'invention, avec masque de protection de l'oxydation latérale et de l'oxydation à travers la couche isolante enterrée, selon une deuxième variante de mise en oeuvre.

### DESCRIPTION DETAILLEE DE MODES DE MISE EN OEUVRE DE L'INVENTION

Le procédé de fabrication part d'un substrat SOI constitué d'un support en silicium supportant une couche d'oxyde de silicium, ou couche d'oxyde enterrée, et d'une couche superficielle de silicium. Le substrat de départ peut aussi être un substrat sSOI (pour « strained SOI » ou SOI contraint). Il peut encore être un substrat XsSOI (pour « eXtrem strained SOI » ou SOI extrêmement contraint). Ces substrats sont avantageux pour permettre une co-intégration SOI contraint en tension/GeOI (ou SGOI) contraint en compression après enrichissement. Sur la couche superficielle de silicium, on forme par épitaxie une couche de SiGe (ou de Si₁₋ₓGeₓ) monocristallin. La concentration et l'épaisseur de la couche de SiGe sont choisies préférentiellement pour que la couche de SiGe soit dans un état de contrainte pseudomorphe. Sur la couche de SiGe crue, on dépose une couche d'oxyde de silicium. Cet oxyde est de préférence un oxyde thermique à haute température ou HTO (pour "High Thermal Oxide").

Selon une première variante de mise en oeuvre de l'invention, on grave des îlots (ou mesa) avec arrêt de la gravure sur la couche d'oxyde enterrée. Chaque îlot comprend alors, sur la couche d'oxyde enterrée, une partie de la couche superficielle de silicium supportant une partie de la couche épitaxiée de SiGe et une partie de la couche d'oxyde de silicium.

On dépose ensuite, sur la structure obtenue une couche de protection de l'oxydation. Cette couche de protection est préférentiellement de type nitrure (SiN ou Si₃N₄) et est déposée par une technique PECVD, LPCVD ou une autre technique CVD dont la température est compatible avec l'empilement sous-jacent. La couche de protection épouse la structure gravée.

Sur la couche de protection, on dépose une couche d'oxyde de silicium supérieure. De préférence, cet oxyde est de type HDP (pour "High Density Plasma"). La nouvelle couche de protection épouse la structure obtenue précédemment.

On réalise ensuite une planarisation mécano-chimique (CMP) de la couche d'oxyde de silicium supérieure avec arrêt sur la couche de protection de l'oxydation.

On réalise ensuite une gravure commune de la partie proéminente de la couche de protection de l'oxydation et pour le matériau de la couche d'oxyde de silicium supérieure avec une chimie de gravure de même vitesse pour le matériau de la couche de protection de l'oxydation et pour le matériau de la couche d'oxyde de silicium supérieure. Cette gravure commune est effectuée jusqu'à son arrêt sur la partie de la couche de protection reposant sur la couche d'oxyde enterrée pour former le masque de protection de l'oxydation.

La structure obtenue est représentée sur la figure 5A. Cette figure montre le support en silicium 11, la couche d'oxyde enterrée 12 et les parties subsistantes 13 de la couche superficielle de silicium du substrat SOI. La référence 14 désigne les îlots (ou mesas) comprenant, en superposition, les parties subsistantes 13 en silicium, les parties subsistantes 15 en SiGe et les parties subsistantes 16 en oxyde de silicium. La référence 17 désigne le masque de protection de l'oxydation entourant les îlots 14 dont seule la couche d'oxyde de silicium 16 affleure.

On procède ensuite à l'enrichissement en germanium sur des zones localisées définies par les îlots, par oxydation sèche à haute température. On obtient, comme le montre la figure 5B une transformation des îlots avec enrichissement en germanium dans les parties subsistantes du silicium superficiel, fournissant, par îlot, une couche de SiGe 18 reposant sur la couche d'oxyde enterrée 12. L'enrichissement peut être tel que la couche 18 est entièrement constituée de germanium. Le reste des îlots est constitué d'oxyde de silicium 19. En éliminant l'oxyde de silicium 19 et le masque 17, on obtient une structure SiGe sur isolant, voire une structure germanium sur isolant.

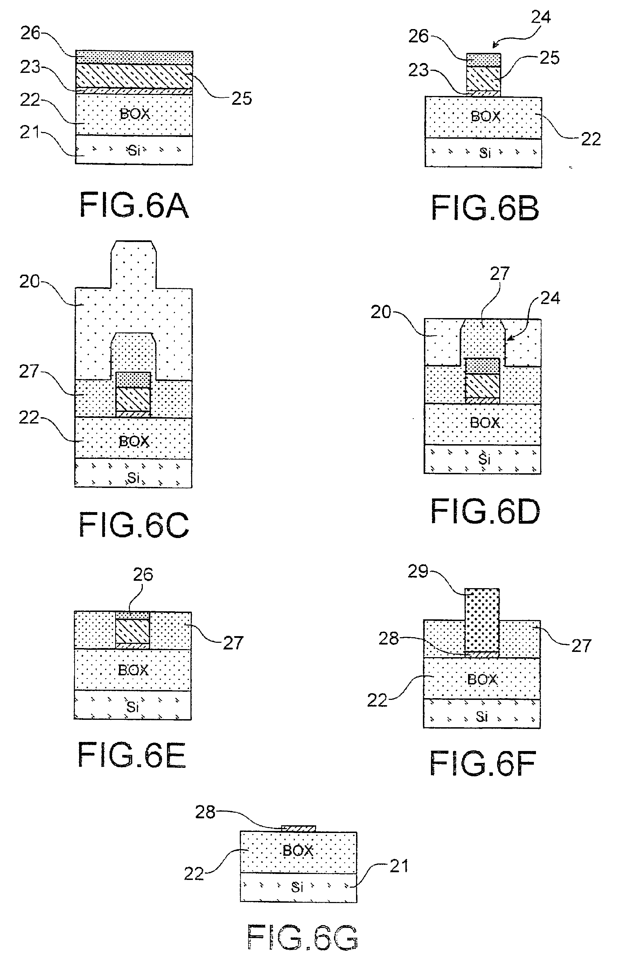

Les figures 6A à 6G illustrent, de manière plus détaillée, différentes étapes du procédé selon l'invention, selon ce mode particulier de mise en oeuvre.

La figure 6A montre un substrat SOI constitué d'un support en silicium 21 supportant une couche d'oxyde de silicium 22 et une couche superficielle de silicium 23. La couche superficielle de silicium 23 supporte successivement une couche épitaxiée 25 de Si₁₋ₓGeₓ et une couche 26 d'oxyde de silicium. Dans ce mode de réalisation, l'épaisseur de la couche d'oxyde 26 est plus épaisse que la différence entre l'épaisseur du masque protecteur à déposer (référencé 27 sur la figure 6C) et l'épaisseur de la bicouche constituée par la couche de silicium 23 et la couche épitaxiée 25 superposées. L'épaisseur du masque protecteur 27 est plus grande que celle de la bicouche.

La figure 6B montre les îlots 24 (ou mesas) obtenus après gravure des couches empilées 23, 25 et 26.

La figure 6C montre la structure obtenue après le dépôt de la couche de protection de l'oxydation 27 suivi du dépôt d'une couche d'oxyde de silicium supérieure 20. On choisira, pour cette couche 20, une épaisseur au moins 2 à 3 fois supérieure à la couche de protection 27, ceci pour permettre un polissage bien adapté.

A titre d'exemple, la couche de SiGe épitaxiée a une épaisseur de 75 nm et une concentration en Ge de 10 % atomique et la couche de silicium superficielle du substrat SOI a une épaisseur de 20 nm. Dans ce cas, on choisira une couche d'oxyde 26 de 40 nm d'épaisseur, un masque protecteur 27 de 120 nm d'épaisseur et une couche d'oxyde 20 de 300 nm d'épaisseur.

On procède ensuite à une étape de planarisation mécano-chimique (CMP) de la couche d'oxyde supérieure 20 avec arrêt sur la partie supérieure de la couche de protection de l'oxydation 27. C'est ce que montre la figure 6D.

On procède ensuite à une gravure simultanée de la couche d'oxyde supérieure 20 et de la partie proéminente de la couche de protection de l'oxydation 27 (celle située sur l'îlot 24) avec arrêt sur la couche de protection formant masque 27. On obtient la structure représentée sur la figure 6E. La couche d'oxyde 26 est alors révélée.

On procède alors à l'enrichissement en germanium pour obtenir une couche de SiGe 28 reposant sur la couche d'oxyde enterrée 22, voire une couche de Ge pur. La couche 28 est surmontée d'une couche d'oxyde de silicium 29. C'est ce que montre la figure 6F.

La couche d'oxyde de silicium 29 et le masque 27 peuvent alors être retirés par gravure pour fournir la structure représentée à la figure 6G.

Le procédé décrit ci-dessus permet d'éviter une étape de planarisation mécano-chimique d'un masque d'oxydation avec arrêt sur la couche d'oxyde présente sur la couche de SiGe dans la réalisation de la figure 5A. En effet, ce type de planarisation est technologiquement critique. En revanche, la planarisation mécano-chimique d'un oxyde avec arrêt sur le masque et la gravure d'un oxyde et d'un masque à la même vitesse sont des étapes technologiquement réalisables.

Au cours de l'étape d'enrichissement en germanium, au moyen d'une oxydation sèche à haute température, il est possible de mettre en évidence des zones appelées « becs d'oiseau » (« bird's beaks » en anglais) dans la couche enrichie en germanium et près du masque de protection de l'oxydation. Ces zones correspondent à des régions où l'oxydation est plus lente. Dans ces zones, les couches de SiGe sont plus épaisses et moins enrichies. Les cinétiques d'oxydation, plus lentes près du masque de protection de l'oxydation, pourraient être attibuées à un effet de contrainte exercée par le masque de protection, effet qui freinerait ainsi l'oxydation. Ces zones non homogènes à l'enrichissement sont à réduire au maximum si l'on veut augmenter la densité d'îlots comprenant une couche enrichie en germanium.

Pour réduire ces zones non homogènes, on peut réaliser le procédé de condensation du germanium (ou d'enrichissement en germanium) par une répétition d'étapes d'oxydation et de désoxydation afin que la couche d'oxyde de silicium formée ne dépasse pas l'épaisseur du masque de protection de l'oxydation. Après chaque étape d'oxydation, il est préférable alors de déposer sur les îlots, une couche d'oxyde de silicium de quelques nanomètres afin de préserver le germanium de l'oxydation lors de la reprise de chaque oxydation. Dans un exemple de mise en oeuvre, on a ainsi pu réduire la largeur de becs d'oiseau de 171 nm à 20 nm.

Une autre possibilité pour réduire les zones non homogènes est de déposer le masque de protection de l'oxydation dans un état de contrainte en tension ou en compression. Ceci permet de jouer sur la contrainte imposée sur les zones d'oxydation et ainsi de diminuer les inhomogénéités des cinétiques d'oxydation.

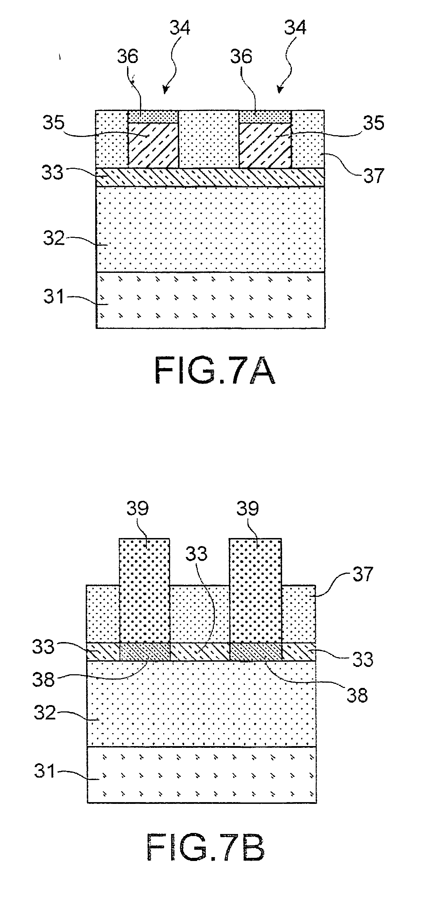

Selon une deuxième variante de mise en oeuvre de l'invention, le procédé permet l'obtention d'une co-intégration côte à côte de zones de Silicium-sur-Isolant ou de Silicium/Germanium-sur-Isolant. Cette deuxième variante est illustrée par les figures 7A et 7B. La seule différence par rapport à la première variante est que, lors de la gravure des îlots (ou mesas), la couche d'arrêt de la gravure est constituée par la couche de silicium superficiel du substrat SOI et non par la couche isolante enterrée.

La figure 7A est à comparer avec la figure 5A. Elle montre un support en silicium 31 supportant une couche d'oxyde enterrée 32 et une couche superficielle de silicium 33. La référence 34 désigne les îlots comprenant chacun, en superposition, une zone de la couche superficielle de silicium, une partie 35 subsistante à la gravure du SiGe (ou Si₁₋ₓGeₓ) et une partie subsistante 36 en oxyde de silicium. La référence 37 désigne le masque de protection de l'oxydation entourant les îlots 34 dont seule la couche d'oxyde de silicium 36 affleure. Dans cette variante, le masque repose sur la couche de silicium 33.

On procède ensuite à l'enrichissement en germanium des zones localisées définies par les îlots, par oxydation sèche à haute température. On obtient, comme le montre la figure 7B une transformation des îlots avec enrichissement en germanium dans les zones de silicium correspondant à ces îlots, fournissant, par îlot, une couche de SiGe 38 (voire une couche de germanium pur) reposant sur la couche d'oxyde enterrée 32. Le reste des îlots est constitué d'oxyde de silicium 39. En éliminant l'oxyde de silicium 39 et le masque 37, on obtient une structure comprenant des zones en SiGe (ou en Ge) sur isolant côtoyant des zones en Si sur isolant.

## Revendications

1. Procédé de fabrication d'un substrat semiconducteur-sur-isolant à partir d'un substrat SOI comportant une couche superficielle de silicium (13, 23, 33) sur une couche électriquement isolante (12, 22, 32), dite couche isolante enterrée, une couche de Si₁₋ₓGeₓ (15, 25, 35) étant formée sur la couche superficielle de silicium, le procédé comprenant les étapes suivantes :
- formation d'une couche d'oxyde de silicium (16, 26, 36) sur la couche de Si₁₋ₓGeₓ,
- gravure de l'empilement constitué par la couche superficielle de silicium, la couche de Si₁₋ₓGeₓ et la couche d'oxyde de silicium, la gravure étant menée soit jusqu'à la couche isolante enterrée pour obtenir une structure gravée avec au moins un îlot (14, 24) dudit empilement, soit jusqu'à la couche superficielle de silicium (33) pour obtenir une structure gravée avec au moins une zone de silicium (33) et au moins un îlot (34) dudit empilement,
- formation d'un masque de protection de l'oxydation (17, 27, 37) sur la structure gravée, la formation du masque de protection de l'oxydation comprenant le dépôt d'une couche de protection de l'oxydation (27) sur la structure gravée, l'épaisseur de la couche de protection de l'oxydation étant supérieure à l'épaisseur cumulée de la couche superficielle de silicium (23) et de la couche de Si₁₋ₓGeₓ (27) et inférieure à l'épaisseur de l'empilement, et la planarisation de la couche de protection de l'oxydation (27) jusqu'à révéler la couche d'oxyde de silicium (26) de l'îlot (24),
- condensation du germanium de la couche de Si₁₋ₓGeₓ de l'îlot, par oxydation sèche à une température supérieure à 900°C de la couche de Si₁₋ₓGeₓ de l'îlot, pour obtenir un îlot comprenant une couche (18, 28, 38) enrichie en germanium, voire une couche de germanium, sur la couche isolante enterrée, surmontée d'une couche d'oxyde de silicium (19, 29, 39).

2. Procédé selon la revendication 1, comprenant en outre, après le dépôt de la couche de protection de l'oxydation (27), le dépôt d'une couche de recouvrement (20) sur la couche de protection de l'oxydation, l'étape de planarisation comprenant le polissage mécano-chimique de la couche de recouvrement (20) avec arrêt sur la partie de la couche de protection de l'oxydation (27) située sur l'îlot (24), puis la gravure simultanée de la couche de protection de l'oxydation (27) et de la couche de recouvrement (20) avec arrêt sur la couche de protection de l'oxydation (27) jusqu'à obtenir ledit masque.

3. Procédé selon la revendication 2, dans lequel la couche de recouvrement (20) est une couche d'oxyde de silicium.

4. Procédé selon la revendication 3, dans lequel la couche de recouvrement (20) est une couche d'oxyde de silicium de type HDP.

5. Procédé selon l'une quelconque des revendications 1 à 4, comprenant en outre, après l'étape de condensation du germanium, une étape d'élimination du masque de protection de l'oxydation (17, 27, 37) et de la couche d'oxyde de silicium (19, 29, 39) surmontant la couche enrichie en germanium (18, 28, 38).

6. Procédé selon l'une quelconque des revendications 1 à 5, dans lequel la couche de Si₁₋ₓGeₓ (15, 25, 35) est formée par épitaxie.

7. Procédé selon l'une quelconque des revendications 1 à 6, dans lequel la couche d'oxyde de silicium (16, 26, 36) formée sur la couche de Si₁₋ₓGeₓ (15, 25, 35) est formée par oxydation thermique à haute température (oxyde HTO).

8. Procédé selon l'une quelconque des revendications 1 à 7, dans lequel la couche isolante enterrée du substrat SOI est une couche d'oxyde de silicium.

9. Procédé selon l'une quelconque des revendications 1 à 8, dans lequel le masque de protection de l'oxydation (17, 27, 37) est en nitrure de silicium.

10. Procédé selon l'un quelconque des revendications 1 à 9, dans lequel l'étape de condensation du germanium comprend une répétition d'étapes d'oxydation et de désoxydation.

11. Procédé selon la revendication 10, dans lequel la répétition d'étapes d'oxydation et de désoxydation est menée pour que ladite couche d'oxyde de silicium surmontant ladite couche enrichie en germanium ne dépasse pas le masque de protection de l'oxydation.

12. Procédé selon l'une quelconque des revendications 1 à 11, dans lequel le masque de protection de l'oxydation est formé dans un état de contrainte en tension ou en compression.

## Patentansprüche

1. Verfahren zur Herstellung eines Halbleiter-auf-Isolator-Substrats ausgehend von einem SOI-Substrat, enthaltend eine Oberflächenschicht aus Silizium (13, 23, 33) auf einer elektrisch isolierenden Schicht (12, 22, 32), vergrabene Isolierschicht genannt, wobei eine Schicht aus Si₁₋ₓGeₓ (15, 25, 35) auf der Oberflächenschicht aus Silizium gebildet wird, wobei das Verfahren nachfolgende Schritte umfasst:
- Bilden einer Schicht aus Siliziumoxid (16, 26, 36) auf der Schicht aus Si₁₋ₓGeₓ,
- Ätzen der Stapelung, die aus der Silizium-Oberflächenschicht, der Schicht aus Si₁₋ₓGeₓ und der Siliziumoxid-Schicht besteht, wobei das Ätzen entweder bis zur vergrabenen Isolierschicht erfolgt, um eine geätzte Struktur der Stapelung mit zumindest einer Insel (14, 24) zu erhalten, oder bis zur Silizium-Oberflächenschicht (33) erfolgt, um eine geätzte Struktur der Stapelung mit zumindest einem Silizium-Bereich (33) und zumindest einer Insel (34) zu erhalten,
- Bilden einer Oxidations-Schutzmaske (17, 27, 37) auf der geätzten Struktur, wobei das Bilden der Oxidations-Schutzmaske das Abscheiden einer Oxidations-Schutzschicht (27) auf die geätzte Struktur umfasst, wobei die Dicke der Oxidations-Schutzschicht größer als die addierte Dicke der Silizium-Oberflächenschicht (23) und der Schicht aus Si₁₋ₓGeₓ (27) und kleiner als die Dicke der Stapelung ist, sowie das Planarisieren der Oxidations-Schutzschicht (27) bis zum Freilegen der Siliziumoxid-Schicht (26) der Insel (24),
- Kondensation von Germanium aus der Si₁₋ₓGeₓ-Schicht der Insel durch Trockenoxidation der Si₁₋ₓGeₓ-Schicht der Insel bei einer Temperatur von über 900 °C, um eine Insel mit einer mit Germanium angereicherten Schicht (18, 28, 38) bzw. eine Germaniumschicht an der vergrabenen Isolierschicht zu erhalten, die von einer Siliziumoxid-Schicht (19, 29, 39) überhöht wird.

2. Verfahren nach Anspruch 1, ferner umfassend nach dem Abscheiden der Oxidations-Schutzschicht (27) das Abscheiden einer Deckschicht (20) auf die Oxidations-Schutzschicht, wobei der Schritt des Planarisierens das mechanisch-chemische Polieren der Deckschicht (20) mit Stopp bei dem an der Insel (24) befindlichen Abschnitt der Oxidations-Schutzschicht (27), gefolgt von dem gleichzeitigen Ätzen der Oxidations-Schutzschicht (27) und der Deckschicht (20) mit Stopp bei der Oxidations-Schutzschicht (27) bis zum Erhalt der genannten Maske umfasst.

3. Verfahren nach Anspruch 2, wobei die Deckschicht (20) eine Siliziumoxidschicht ist.

4. Verfahren nach Anspruch 3, wobei die Deckschicht (20) eine Siliziumoxidschicht vom Typ HDP ist.

5. Verfahren nach einem der Ansprüche 1 bis 4, ferner umfassend nach dem Schritt der Kondensation von Germanium einen Schritt des Beseitigens der Oxidations-Schutzmaske (17, 27, 37) und der Siliziumoxidschicht (19, 29, 39), welche die mit Germanium angereicherte Schicht (18, 28, 38) überhöht.

6. Verfahren nach einem der Ansprüche 1 bis 5, wobei die Schicht aus Si₁₋ₓGeₓ (15, 25, 35) durch Epitaxie gebildet wird.

7. Verfahren nach einem der Ansprüche 1 bis 6, wobei die auf der Schicht aus Si₁₋ₓGeₓ (15, 25, 35) gebildete Siliziumoxidschicht (16, 26, 36) durch thermische Oxidation bei hoher Temperatur (HTO-Oxid) gebildet wird.

8. Verfahren nach einem der Ansprüche 1 bis 7, wobei die vergrabene Isolierschicht des SOI-Substrats eine Siliziumoxidschicht ist.

9. Verfahren nach einem der Ansprüche 1 bis 8, wobei die Oxidations-Schutzmaske (17, 27, 37) aus Siliziumnitrid besteht.

10. Verfahren nach einem der Ansprüche 1 bis 9, wobei der Schritt der Kondensation von Germanium eine Wiederholung von Oxidations- und Desoxidationsschritten umfasst.

11. Verfahren nach Anspruch 10, wobei die Wiederholung von Oxidations- und Desoxidationsschritten dazu erfolgt, damit die Siliziumoxidschicht, welche die mit Germanium angereicherte Schicht überhöht, nicht die Oxidations-Schutzmaske übersteigt.

12. Verfahren nach einem der Ansprüche 1 bis 11, wobei die Oxidations-Schutzmaske in einem Zustand von Zug- oder Druckbeanspruchung gebildet wird.

## Claims

1. Manufacturing method of a semi-conductor on insulator substrate from an SOI substrate comprising a superficial layer of silicon (13, 23, 33) on a electrically insulating layer (12, 22, 32), called buried insulating layer, wherein a layer of Si₁₋ₓGeₓ (15, 25, 35) is formed on the superficial layer of silicon, wherein the method comprises the following steps:
- formation of a silicon oxide layer (16, 26, 36) on the layer of Si₁₋ₓGeₓ,
- etching of the stack formed by the superficial layer of silicon, the layer of Si₁₋ₓGeₓ and the silicon oxide layer, wherein the etching is carried out either up to the buried insulating layer to obtain an etched structure with at least one island (14, 24) of said stack, or up to the superficial layer of silicon (33) to obtain an etched structure with at least one zone of silicon (33) and at least one island (34) of said stack,
- formation of a mask to protect against oxidation (17, 27, 37) on the etched structure, the formation of the mask which protects against oxidation comprising the deposition of a layer which protects against oxidation (27) on the etched structure, wherein the layer which protects against oxidation is thicker than the combined thickness of the superficial layer of silicon (23) and the layer of Si₁₋ₓGeₓ (27) and thinner than the thickness of the stack, and the planarisation of the layer which protects against oxidation (27) until the silicon oxide layer (26) of the island (24) is revealed,
- condensation of the germanium of the layer of Si₁₋ₓGeₓ on the island, by dry oxidation at a temperature higher than 900°C of the layer of Si₁₋ₓGeₓ on the island, to obtain an island comprising a layer (18, 28, 38) that is enriched in germanium, or even a layer of germanium, on the buried insulating layer, with a silicon oxide layer on top of it (19, 29, 39).

2. Method according to claim 1, **characterised in that**, after the deposition of the layer which protects against oxidation (27), the deposition of a covering layer (20) on the layer which protects against oxidation, the planarisation step comprises the chemical-mechanical polishing of the covering layer (20) which stops on the part of the layer which protects against oxidation (27) located on the island (24), then the simultaneous etching of the layer which protects against oxidation (27) and the covering layer (20) which stops on the layer which protects against oxidation (27) until said mask is obtained.

3. Method according to claim 2, **characterised in that** the covering layer (20) is a silicon oxide layer.

4. Method according to claim 3, **characterised in that** the covering layer (20) is a HDP type silicon oxide layer.

5. Method according to any of claims 1 to 4, **characterised in that**, following the germanium condensation step, there is a step for eliminating the mask which protects against oxidation (17, 27, 37) and the silicon oxide layer (19, 29, 39) on top of the germanium enriched layer (18, 28, 38).

6. Method according to any of claims 1 to 5, **characterised in that** the layer of Si₁₋ₓGeₓ (15, 25, 35) is formed by epitaxy.

7. Method according to any of claims 1 to 6, **characterised in that** the silicon oxide layer (16, 26, 36) formed on the layer of Si₁₋ₓGeₓ (15, 25, 35) is formed by thermal oxidation at high temperature (HTO oxide).

8. Method according to any of claims 1 to 7, **characterised in that** the buried insulating layer of the SOI substrate is a silicon oxide layer.

9. Method according to any of claims 1 to 8, **characterised in that** the mask which protects against oxidation (17, 27, 37) is made of silicon nitride.

10. Method according to any of claims 1 to 9, **characterised in that** the germanium condensation step comprises a repetition of oxidation and de-oxidation steps.

11. Method according to claim 10, **characterised in that** the repetition of oxidation and de-oxidation steps is carried out so that said silicon oxide layer on top of said germanium enriched layer does not overshoot the mask which protects against oxidation.

12. Method according to any of claims 1 to 11, **characterised in that** the mask which protects against oxidation is formed in a state of tension or compression strain.
